# DEMANDE DE BREVET EUROPEEN

(11) **EP 4 772 668 A1**
(43) Date de publication de la demande: **08.07.2026**
(21) Numéro de dépôt: 25224359.7
(22) Date de dépôt: 17.12.2025
(51) Int. Cl.: C23C 14/24, C23C 14/26, C23C 14/50, C23C 14/54, H10K 85/50, C23C 14/06, C23C 14/12

(54) **DISPOSITIF ET PROCEDE DE DEPOT PHYSIQUE PAR SUBLIMATION A FAIBLE DISTANCE**

(30) Priorité: 20.12.2024 GR 20240100914; 24.12.2024 FR 2415252
(71) Demandeur: Commissariat à l'Energie Atomique et aux Energies Alternatives, 75015 Paris (FR)
(72) Inventeur: WYTTENBACH, Joël, 38054 GRENOBLE CEDEX 09 (FR); TSOULKA, Polyxeni, 38054 GRENOBLE CEDEX 09 (FR); BERSON, Solenn, 38054 GRENOBLE CEDEX 09 (FR); BENMANSOUR, Malek, 38054 GRENOBLE CEDEX 09 (FR)
(74) Mandataire: Regimbeau

(57) **Abrégé**

L'invention concerne un dispositif de dépôt physique par sublimation à faible distance, comprenant :
- une enceinte (3) sous vide comprenant un corps (30) et un couvercle (40) monté hermétiquement sur le corps,
- au moins deux stations de dépôt (1, 2) comprenant chacune :
• un compartiment (10, 20) agencé dans le corps de l'enceinte (3) et comprenant un creuset (11, 21) adapté pour être rempli d'un matériau cible (12, 22), et
• un élément chauffant (13, 23) adapté pour chauffer le creuset (11, 21) à une température de sublimation du matériau cible,
chaque compartiment (10) étant découplé thermiquement d'un autre compartiment (20),
- un carrousel (4) adapté pour supporter au moins un substrat (S1, S2), le carrousel étant monté en rotation dans l'enceinte (3) pour positionner ledit substrat (S1, S2) de manière alternée en regard de chaque creuset (11, 21) pour permettre un dépôt d'une couche du matériau cible respectif sur le substrat, et
- des moyens de contrôle de la température (5) dudit au moins un substrat pour refroidir chaque substrat à une température inférieure à la température de sublimation de chaque matériau cible.

## Description

### DOMAINE TECHNIQUE

L'invention concerne un dispositif de dépôt physique par sublimation à faible distance, ainsi qu'un procédé mis en œuvre grâce à un tel dispositif.

### ETAT DE LA TECHNIQUE

Le dépôt physique par sublimation à faible distance, également désigné par l'acronyme CSS (du terme anglo-saxon « Close Space Sublimation ») est une technique de dépôt physique en phase vapeur qui permet de déposer une couche complexe à partir de différents précurseurs quasi-simultanément.

A cet effet, un dispositif de dépôt physique par sublimation à faible distance comprend une enceinte sous vide dans laquelle sont disposés une cible et un substrat à faible distance l'un de l'autre (typiquement, inférieure à 10 mm). La cible est constituée du matériau qui doit être déposé sur le substrat. La cible est chauffée à une température adaptée pour permettre la sublimation du matériau. La cible et le substrat présentant des dimensions similaires, l'ensemble de la surface du substrat reçoit la vapeur du matériau sublimé, qui s'y dépose.

Ce procédé ne comporte donc aucun bombardement ionique, électronique ni n'utilise de laser.

Pour la fabrication de certains matériaux, notamment les pérovskites, il est nécessaire de combiner différents matériaux, inorganiques et organiques, selon une stœchiométrie contrôlée.

Cependant, les dispositifs existants ne permettent pas un dépôt dans des conditions suffisamment précises pour obtenir la stœchiométrie souhaitée.

### RESUME DE L'INVENTION

Un but de l'invention est de concevoir un dispositif de sublimation à faible distance amélioré, permettant notamment de contrôler plus précisément l'épaisseur d'au moins deux matériaux déposés sur un substrat.

A cet effet, l'invention propose un dispositif de dépôt physique par sublimation à faible distance, comprenant :
- une enceinte sous vide comprenant un corps et un couvercle monté hermétiquement sur le corps,
- au moins deux stations de dépôt comprenant chacune :
   - un compartiment agencé dans le corps de l'enceinte et comprenant un creuset adapté pour être rempli d'un matériau cible, et
   - un élément chauffant adapté pour chauffer le creuset à une température de sublimation du matériau cible,
   chaque compartiment étant découplé thermiquement d'un autre compartiment,
- un carrousel adapté pour supporter au moins un substrat, le carrousel étant monté en rotation dans l'enceinte pour positionner ledit substrat de manière alternée en regard de chaque creuset pour permettre un dépôt d'une couche du matériau cible respectif sur le substrat, et
- des moyens de contrôle de la température dudit au moins un substrat pour refroidir chaque substrat à une température inférieure à la température de sublimation de chaque matériau cible.

Dans ce dispositif, le carrousel permet de commuter rapidement le substrat d'une station à l'autre et ainsi de contrôler précisément l'épaisseur de chaque couche déposée.

Selon des caractéristiques avantageuses mais optionnelles, éventuellement prises en combinaison :
- les moyens de contrôle de la température du substrat comprennent un radiateur agencé dans ou sur le couvercle de l'enceinte pour évacuer la chaleur émise par chaque élément chauffant,
- les moyens de contrôle de la température du substrat comprennent un circuit de fluide agencé dans ou sur le couvercle,
- les moyens de contrôle de la température du substrat comprennent au moins un élément Peltier monté sur le couvercle,
- le dispositif comprend une unité de contrôle configurée pour piloter les éléments chauffants et la rotation du carrousel en fonction des matériaux cibles et de l'épaisseur de chaque couche à déposer sur le substrat,
- le couvercle est amovible par rapport au corps par l'intermédiaire d'une glissière s'étendant dans une direction parallèle à l'axe de rotation du carrousel,
- le carrousel est agencé de sorte que la distance entre chaque substrat et un creuset en regard duquel ledit substrat est positionné soit inférieure ou égale à 10 mm,
- le carrousel présente une pluralité d'ouvertures, chaque ouverture présentant un support pour un substrat respectif de sorte que ledit substrat comble l'ouverture,
- le dispositif comprend au moins un compartiment adapté pour ne pas être chauffé entre deux stations de dépôt.

Un autre objet de l'invention concerne un procédé mis en œuvre par le dispositif décrit ci-dessus. Ledit procédé comprend :
- le chargement d'au moins deux matériaux cibles différents dans des creusets respectifs dudit dispositif,
- la mise en place d'au moins un substrat sur le carrousel,
- le chauffage des creusets à une température de sublimation de chaque matériau cible respectif,
- la mise en rotation contrôlée du carrousel en regard des stations de dépôt, de sorte à déposer successivement sur chaque substrat une couche de chaque matériau cible respectif.

Selon d'autres caractéristiques avantageuses mais optionnelles dudit procédé, éventuellement prises en combinaison :
- le dispositif comprend au moins un compartiment adapté pour ne pas être chauffé entre deux stations de dépôt et, avant et après le dépôt, le carrousel est placé dans une position dans laquelle chaque substrat est en regard d'un compartiment non chauffé,
- le carrousel présente une pluralité d'ouvertures, chaque ouverture présentant un support pour un substrat respectif de sorte que ledit substrat comble l'ouverture et, si le nombre de substrats est inférieur au nombre d'ouvertures dans le carrousel, chaque ouverture non comblée par un substrat est obturée par une plaque amovible,
- les procédé est employé pour former une couche de pérovskite sur ledit au moins un substrat, les matériaux cibles étant des précurseurs de ladite pérovskite, la mise en rotation du carrousel étant contrôlée pour déposer, sur le substrat, des couches d'une épaisseur déterminée selon une proportion stœchiométrique,
- les précurseurs comprennent deux matériaux inorganiques, tels que YX avec Y = Cs, K, Na ou Rb et X = I, Br ou Cl, et PbX2 avec X = I, Br ou Cl, et un matériau organique, tel que FAX ou MAX avec X = I, Br ou Cl, chaque matériau présentant une température de sublimation différente.

### BREVE DESCRIPTION DES FIGURES

D'autres caractéristiques et avantages de l'invention ressortiront de la description détaillée qui va suivre, en référence aux dessins annexés, sur lesquels :
- la figure 1 illustre deux vues en coupe d'un dispositif selon un mode de réalisation de l'invention ;
- la figure 2A, la figure 2B et la figure 2C illustrent, en coupe partielle, trois positions différentes du carrousel pendant un procédé de dépôt physique par sublimation à faible distance selon l'invention ;
- la figure 3 est une vue en coupe partielle d'un substrat recouvert de deux couches déposées par sublimation à faible distance.

Pour des raisons de lisibilité des figures, les différents éléments ne sont pas nécessairement représentés à l'échelle.

### DESCRIPTION DETAILLEE DE MODES DE REALISATION

Le dispositif de dépôt physique par sublimation à faible distance comprend une enceinte apte à être mise sous vide.

L'enceinte est destinée à recevoir des creusets contenant chacun un matériau cible, et au moins un substrat sur lequel chaque matériau cible doit être déposé.

A cet effet, l'enceinte comprend un corps et un couvercle monté hermétiquement sur le corps.

De manière générale, le corps comprend un fond qui s'étend sensiblement dans un plan horizontal, c'est-à-dire parallèle à la surface du sol du bâtiment dans lequel le dispositif de dépôt est installé. Le couvercle s'étend également sensiblement dans un plan horizontal, parallèle au fond du corps. La suite de la description est basée sur cette orientation horizontale du fond. Cependant, l'invention n'est pas limitée à ce mode de réalisation et le fond pourrait, par exemple, être orienté verticalement.

Le couvercle est amovible vis-à-vis du corps, afin notamment de permettre la mise en place des matériaux cibles dans les creusets et des substrats, ainsi que le nettoyage et la maintenance des éléments agencés dans l'enceinte.

De manière particulièrement avantageuse, le couvercle est mobile en translation selon un axe vertical, entre une position de fermeture, dans lequel il repose sur un bord supérieur du corps, et une position d'ouverture, dans lequel il est distant dudit bord supérieur du corps. Dans la position d'ouverture, la distance entre le bord supérieur du corps et le couvercle est suffisante pour permettre l'accès à l'intérieur de l'enceinte et notamment la mise en place des creusets et du ou des substrats.

De préférence, le dispositif comprend des moyens de maintien du couvercle dans la position d'ouverture. Par exemple, ces moyens d'ouverture peuvent comprendre des taquets qui permettent d'empêcher le couvercle de redescendre une fois que la position d'ouverture a été atteinte.

Naturellement, d'autres cinématiques du couvercle pour permettre l'ouverture et la fermeture de l'enceinte sont possibles sans pour autant sortir du cadre de la présente invention. Ces cinématiques peuvent comprendre au moins une translation dans un plan horizontal, et/ou une rotation.

Le corps est en liaison fluidique avec une pompe à vide qui permet de créer une dépression dans l'enceinte lorsque le couvercle est en position de fermeture. Pour les besoins du dépôt physique par sublimation à faible distance, la pression dans l'enceinte peut varier typiquement entre la pression atmosphérique (10⁵ Pa) hors des opérations de dépôt, avant la mise sous vide, et une pression de l'ordre de 0,1 à 1500 Pa pendant le dépôt.

Le dispositif comprend au moins deux stations de dépôt. Chaque station de dépôt comprend un creuset rempli d'un matériau cible respectif et un élément chauffant adapté pour chauffer le creuset à une température de sublimation du matériau cible.

Le dispositif comprend en outre un carrousel logé dans l'enceinte, supportant un ou plusieurs substrats. Ledit carrousel est mobile en rotation autour d'un axe vertical, de sorte à amener chaque substrat successivement en regard de chaque creuset. Pour un dépôt physique par sublimation à faible distance, le carrousel est positionné de telle sorte que la surface de chaque substrat soit à une distance inférieure à 10 mm de la surface de chaque creuset. Le carrousel est amovible pour permettre notamment l'accès aux creusets.

L'enceinte est subdivisée en une pluralité de compartiments disposés autour de l'axe de rotation du carrousel.

Les compartiments sont découplés thermiquement les uns des autres, chaque compartiment étant dimensionné pour recevoir un creuset. En d'autres termes, chaque compartiment appartient à une station de dépôt respective.

Par découplage thermique, on entend qu'une certaine isolation thermique et fluidique est prévue entre les compartiments, suffisante pour ajuster la température de chaque creuset à la température de sublimation du matériau cible qu'il contient. Comme on le décrira en détail plus bas, il n'est pas possible de rendre les compartiments étanches les uns vis-à-vis des autres car il est nécessaire de ménager un passage pour le carrousel afin de déplacer chaque substrat d'un compartiment à un autre. Le découplage thermique est avantageusement réalisé par des cloisons verticales qui s'étendent sur la majeure partie de la hauteur du corps de l'enceinte, en laissant un jeu minimal entre le bord supérieur desdites cloisons et la surface inférieure du carrousel pour minimiser le passage de la vapeur du matériau cible du compartiment à un autre compartiment.

Par ailleurs, selon le nombre de matériaux cibles à sublimer, tous les compartiments ne sont pas nécessairement pourvus d'un creuset. Le découplage thermique peut ainsi être assuré en maintenant une certaine distance entre les stations de dépôt, en faisant en sorte que leurs compartiments respectifs ne soient pas immédiatement adjacents. Par exemple, si le dispositif comprend deux stations de dépôt, celles-ci sont avantageusement diamétralement opposées par rapport à l'axe de rotation du carrousel, et sont séparées par deux compartiments vides diamétralement opposés l'un à l'autre. En tout état de cause, au moins un compartiment ou une station de dépôt doit être non chauffé pour servir de position initiale et finale à chaque substrat.

Avantageusement, creusets et substrats sont placés de telle sorte que lorsqu'un substrat est déplacé d'une station de dépôt à une autre, l'ensemble des substrats opère une permutation circulaire qui place chacun d'eux face à une station de dépôt.

Typiquement, l'élément chauffant est agencé sous le creuset. L'élément chauffant peut être agencé dans l'enceinte, dans le compartiment contenant le creuset. Cependant, il est plus avantageux, pour faciliter la maintenance de l'élément chauffant et d'éviter son encrassement par le matériau cible lors du dépôt, de l'agencer en-dehors de l'enceinte, juste en-dessous du creuset qui est disposé sur le fond du corps de l'enceinte. L'élément chauffant peut alors chauffer le creuset par conduction au travers du fond de l'enceinte.

L'élément chauffant peut comprendre au moins une résistance chauffante alimentée électriquement, ou tout autre moyen de chauffage approprié.

L'élément chauffant présente avantageusement une surface chauffante de dimensions similaires ou légèrement supérieures à celles des creusets, afin de favoriser un chauffage homogène du contenu des creusets.

Chaque élément chauffant est contrôlé indépendamment des autres. Il est ainsi possible de régler les éléments chauffants à des températures très différentes selon les matériaux cibles employés.

Compte tenu de la proximité avec les creusets, les substrats sont inévitablement chauffés par ceux-ci. Cependant, pour permettre le dépôt du matériau cible sur les substrats, la température de surface des substrats doit être inférieure à la température de sublimation des matériaux cibles. Le dispositif comprend donc des moyens de contrôle de la température des substrats, qui peuvent être actifs ou passifs. Ces moyens ne peuvent en principe pas être disposés dans l'enceinte elle-même et sont avantageusement prévus du côté extérieur du couvercle. Parmi les moyens passifs, on peut citer un radiateur composé d'ailettes permettant un flux convectif de la chaleur depuis le couvercle. Parmi les moyens actifs, on peut citer un circuit forcé de fluide à une température contrôlée le long de la surface du couvercle. Dans les deux cas, la température extérieure du couvercle se propage par conduction à travers la paroi du couvercle jusqu'à la surface interne en regard du carrousel. En l'absence d'atmosphère, le rayonnement de cette paroi sur le carrousel modifie la température de ce dernier de sorte à tendre vers celle de la paroi du couvercle.

Le dispositif répond donc à différentes contraintes de nature mécanique, thermique et chimique qui peuvent s'opposer les unes aux autres. En effet, l'enceinte doit permettre simultanément de tenir le vide nécessaire à la sublimation, de contrôler la température des compartiments à des valeurs différentes selon les matériaux, de contrôler la température des substrats à des températures homogènes et inférieures à celle des cibles, et d'assurer un dépôt alterné depuis plusieurs cibles de matériaux différents, sans contamination croisée.

Le principe de carrousel permet le dépôt alterné de différentes couches de manière rapide.

L'enceinte doit présenter une rigidité mécanique permettant de résister à la dépression lors de la mise en œuvre du procédé. En effet, une pression de l'ordre de 10⁵ Pa, imposée par la chimie de la sublimation à faible distance, tend à déformer fortement une géométrie circulaire, d'autant plus que le diamètre est grand. Pour éviter une telle déformation, il est souhaitable de renforcer la rigidité du fond et du couvercle, et/ou d'ajouter des points d'appui supplémentaires.

La rigidité du fond de l'enceinte peut être assurée par des nervures disposées sur la face extérieure du fond. Lorsque les éléments chauffants sont agencés à l'extérieur de l'enceinte, lesdites nervures peuvent être disposées entre les éléments chauffants.

La rigidité du couvercle peut être assurée par des nervures disposées sur la face extérieure du couvercle. La face intérieure doit en effet être maintenue lisse pour que l'échange radiatif avec les substrats soit homogène. De manière particulièrement avantageuse, les nervures prévues sur la face extérieure du couvercle peuvent être conçues pour contribuer à la régulation de la température des substrats.

Pour une régulation thermique passive, les nervures forment des ailettes favorisant une convection naturelle de la chaleur de la surface du couvercle vers l'extérieur. La géométrie des ailettes peut être optimisée par des simulations croisées de leur comportement mécanique et thermique.

Pour une régulation thermique active, on prévoit un circuit fluidique en boucle fermée sur la face extérieure du couvercle. Le circuit fluidique est agencé de sorte à maximiser l'échange thermique sur la surface du couvercle. De manière avantageuse, les nervures assurant la rigidification du couvercle peuvent aussi former les parois du circuit de circulation forcée du fluide.

Selon un autre mode de réalisation, la régulation thermique active peut être réalisée sans circulation d'un fluide par un ou plusieurs éléments Peltier.

A l'intérieur de l'enceinte, les parois verticales qui s'étendent depuis le fond du corps pour délimiter les compartiments contribuent non seulement à éviter la contamination croisée entre les cibles mais aussi à rigidifier le corps de l'enceinte.

Par ailleurs, la présence du carrousel empêche l'utilisation de points d'appui entre le corps et le couvercle ailleurs qu'à la périphérie où est réalisée l'étanchéité entre le corps et le couvercle. Il est en revanche possible d'ajouter un appui au niveau de l'axe de rotation du carrousel. Avantageusement, cet appui est réalisé par un roulement démontable capable de supporter une charge dans le sens de son axe de rotation, agencé au centre du carrousel.

Revenant aux contraintes thermiques, il y a une contrainte contradictoire entre un objectif de différencier les températures entre compartiments de sublimation (pour tenir compte de la différence entre les matériaux cibles) et un objectif d'homogénéiser la température à l'intérieur de ces mêmes compartiments (pour assurer un dépôt homogène sur les substrats). La différence thermique entre creuset et substrat est générée par une chauffe conductive côté creuset (à l'intérieur ou à l'extérieur de l'enceinte) et un refroidissement radiatif du côté du substrat, par le couvercle.

Par ailleurs, pour limiter la conduction thermique entre les compartiments, l'enceinte prévoit un espacement suffisant entre compartiments. D'autre part, l'épaisseur des parois verticales délimitant les compartiments est optimisée pour contribuer à la rigidité de l'enceinte tout en limitant la conduction thermique entre compartiments.

Le dispositif peut être piloté totalement ou partiellement par un opérateur.

Avantageusement, le dispositif comprend une unité de contrôle configurée pour piloter la température des éléments chauffants et du moyen de refroidissement actif, le cas échant, et pour piloter la rotation du carrousel. A cet effet, l'unité de contrôle comprend au moins un processeur adapté pour implémenter un algorithme permettant de calculer la température et le temps de séjour du substrat en face de chaque station à partir de données d'entrées relatives aux matériaux cibles et à l'épaisseur souhaitée de chaque couche de matériau cible.

Une séquence de fonctionnement du dispositif selon l'invention peut être la suivante (certaines des étapes mentionnées pouvant être mises en œuvre simultanément ou dans un ordre différent) :
(1) ouverture du couvercle
(2) remplissage des creusets avec les matériaux cibles
(3) mise en place du carrousel
(4) disposition d'au moins un substrat dans une ouverture respective du carrousel et, le cas échéant, comblement des ouvertures non utilisées par des plaques
(5) fermeture du couvercle pour rendre l'enceinte hermétique
(6) tirage au vide de l'enceinte
(7) positionnement du carrousel pour que chaque substrat soit en regard d'une station non chauffée
(8) activation des éléments chauffants sous les creusets des stations de dépôt chauffées, lesdits éléments chauffants étant réglés séparément à la température requise pour la sublimation du matériau cible
(9) dans le cas d'un moyen de contrôle actif de la température du couvercle, activation de ce moyen et réglage à la température souhaitée pour refroidir le(s) substrat(s)
(10) lorsque les températures souhaitées sont atteintes pour les éléments chauffants et, le cas échéant, le moyen de contrôle de la température du couvercle, le carrousel est entraîné en rotation pour placer chaque substrat face à une station de dépôt chauffée
(11) après un temps déterminé choisi pour déposer une épaisseur déterminée de matériau sur les substrats, le carrousel est à nouveau entraîné en rotation pour placer chaque substrat face à la station de dépôt suivante. Par exemple dans le cas de deux stations de dépôt chauffées, chaque substrat permute entre les deux stations de dépôt.
(12) répétition de l'opération 11 selon le nombre de stations puis retour du carrousel à la position de l'étape 10 et mise en œuvre d'un nouveau cycle des étapes 10, 11 et 12. Dans le cas de deux matériaux, on dépose ainsi une très fine couche de l'un puis de l'autre puis à nouveau du premier et ainsi de suite jusqu'à l'épaisseur finale voulue. Cette disposition permet de combiner l'avantage de la vitesse du dépôt par sublimation à faible distance avec celui de la simultanéité de la co-évaporation. Lorsque plus de deux matériaux sont utilisés, on dépose alors de fines épaisseurs de chaque matériau avant de recommencer avec le premier.
(13) lorsque le dépôt est terminé, positionnement du carrousel de sorte que chaque substrat soit face à une station non chauffée
(14) ouverture du couvercle pour récupérer les substrats.

La rotation des substrats vers des stations vides et non chauffées permet de stopper le dépôt quasi instantanément. De par cette rotation, le carrousel remplit une fonction similaire à celle d'un obturateur (« shutter »).

Les opérations préparatoires et postérieures au dépôt peuvent être réalisées manuellement par un opérateur. Le fonctionnement du dispositif pendant le dépôt est avantageusement piloté automatiquement par l'unité de contrôle.

Selon le nombre de stations de dépôt et de substrats, on peut prévoir différentes configurations des substrats sur le carrousel et des stations.

Exemple 1 : un seul substrat et deux creusets remplis de matériaux à déposer

Le placement angulaire du carrousel se fait sur trois positions particulières :
- le substrat fait face à une station vide au début et à la fin du procédé
- le substrat est alternativement face à l'une ou l'autre des stations de dépôt.

Exemple 2 : deux substrats et deux creusets remplis de matériaux à déposer :
Les substrats sont positionnés à 180° l'un de l'autre, de même que les stations de dépôt. Le placement angulaire du carrousel se fait sur trois positions particulières :
- les substrat sont face aux stations vides au début et à la fin du procédé
- les substrats sont alternativement face à l'une ou l'autre des stations de dépôt

Exemple 3 : un seul substrat et trois creusets remplis de matériaux à déposer :
Le placement angulaire du carrousel se fait sur quatre positions particulières :
- le substrat fait face à la station vide au début et à la fin
- le substrat fait alternativement face à la première, deuxième ou troisième station de dépôt.

Le même concept peut être étendu à plus de quatre emplacements, dès lors qu'il existe un placement angulaire initial et final selon lequel chaque substrat fait face à une station vide et non chauffée.

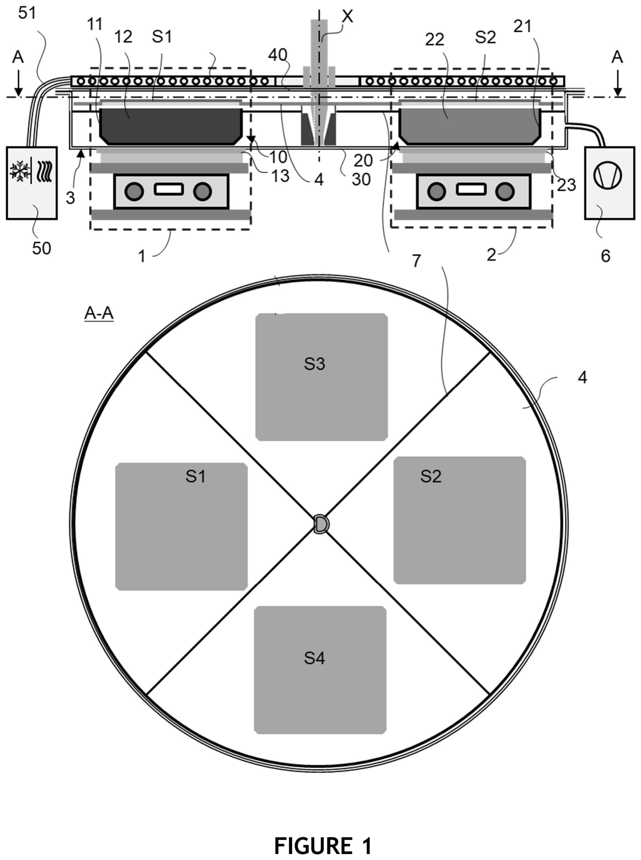

La figure 1 illustre un mode de réalisation d'un dispositif selon l'invention.

Le dispositif comprend une enceinte 3 reliée à une pompe à vide 6 permettant d'appliquer une dépression contrôlée dans l'enceinte.

L'enceinte 3 comprend un corps 30 de forme générale cylindrique à base circulaire et un couvercle 40 mobile entre une position ouverte permettant l'accès à l'intérieur de l'enceinte et une position fermée où il obture hermétiquement sur le corps.

L'enceinte comprend deux stations de dépôt 1, 2 diamétralement opposées l'une par rapport à l'autre.

Chaque station de dépôt, qui est identifiée par un cadre en pointillés, comprend un compartiment 10, 20 respectif agencé dans le corps 30.

Chaque compartiment comprend un creuset 11, 21 respectif adapté pour être rempli d'un matériau cible 12, 22 respectif.

Chaque station de dépôt comprend en outre un élément chauffant 13, 23 respectif adapté pour chauffer le creuset à une température de sublimation du matériau cible.

Les compartiments sont délimités par des parois verticales 7 qui s'étendent depuis le fond du corps 30. Lesdites parois permettent d'éviter la contamination d'un compartiment par un matériau d'un compartiment adjacent. Les parois procurent également un découplage thermique entre les compartiments. Elles contribuent également à rigidifier le corps de l'enceinte.

Les substrats à recouvrir des matériaux cibles sont agencés sur un carrousel 4 monté en rotation dans l'enceinte entre la surface supérieure des creusets et le couvercle. Le carrousel comprend quatre ouvertures traversantes adaptées à la dimension des substrats et un support permettant de maintenir le substrat dans l'ouverture. Par exemple, lorsque les substrats sont de forme carrée, le support peut se présenter sous la forme d'une protrusion s'étendant dans le plan du carrousel dans chaque coin de l'ouverture, le substrat étant simplement posé sur les protrusions. Chaque substrat est mis en place sur le dessus du carrousel avec la face destinée à recevoir les matériaux cibles orientée vers les creusets. La distance entre ladite face des substrats et la surface supérieure des creusets est inférieure à 10 mm.

Dans le cas où on souhaite utiliser moins de quatre substrats, on obture les ouvertures non utilisées du carrousel avec une plaque. Par exemple, les substrats S1 et S2, qui sont diamétralement opposés, sont des substrats destinés à recevoir les matériaux cibles, et les substrats S3 et S4 sont des plaques permettant simplement d'obturer les ouvertures du carrousel.

Dans le mode de réalisation illustré sur la figure 1, le contrôle de la température des substrats est assuré par un circuit de fluide 5 agencé sur le couvercle. Le circuit comprend un réservoir de fluide 50 comprenant des moyens de contrôle de la température du fluide (chauffage et/ou refroidissement) et une boucle de fluide 51 comprenant une entrée et une sortie en liaison fluidique avec le réservoir 50. La boucle de fluide comprend avantageusement des canaux disposés sur la surface extérieure du couvercle, permettant une circulation du fluide entre l'entrée et la sortie en parcourant la majorité de la surface du couvercle. Ces canaux peuvent être rapportés sur la surface du couvercle mais, comme indiqué plus haut, ils peuvent être délimités par des nervures s'étendant directement depuis la surface extérieure du couvercle, afin de combiner contrôle de la température et rigidité du couvercle.

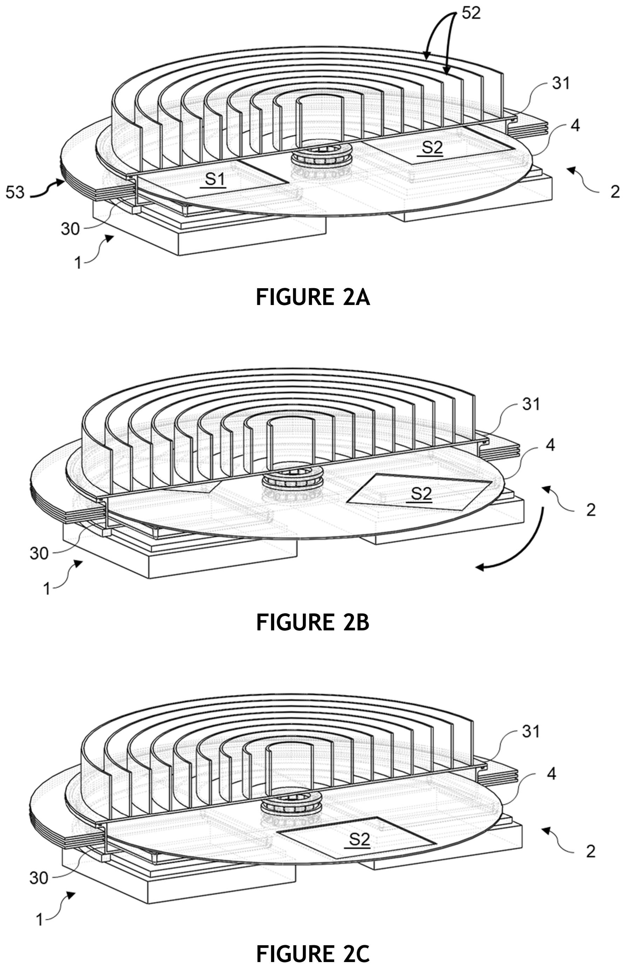

Dans d'autres modes de réalisation, le couvercle peut être pourvu de nervures formant des ailettes permettant à la fois une convection thermique et une rigidité mécanique. Par exemple, comme illustré sur les figures 2A-2C, les nervures 52 sont agencées de manière concentrique sur la surface extérieure du couvercle.

Il est également possible de prévoir des ailettes sur la surface circonférentielle du corps, pour assurer également une convection latérale. Par exemple, comme illustré sur les figures 2A-2C, les ailettes 53 s'étendent dans une direction radiale depuis la surface extérieure du corps.

Les figures 2A à 2C représentent, en coupe partielle, différentes étapes d'une séquence de dépôt alterné de deux matériaux cibles sur deux substrats.

Sur la figure 2A, chaque substrat S1, S2 est agencé en regard d'un creuset respectif des stations de dépôt 1 et 2. L'élément chauffant de chaque station de dépôt est activé à une température adaptée pour provoquer la sublimation du matériau cible et le déposer sur le substrat.

Une fois que l'épaisseur souhaitée de matériau est déposée sur chaque substrat, le carrousel est actionné en rotation, par exemple dans le sens horaire (figure 2B). Dans la position de la figure 2C, les substrats sont en regard d'une station non chauffée, ce qui permet de stopper le dépôt.

On peut procéder à autant de commutations que nécessaire pour déposer l'alternance de matériaux souhaitée sur les substrats.

Ensuite, on ouvre le couvercle de l'enceinte pour accéder au carrousel et retirer les substrats. De nouveaux substrats peuvent être placés dans les logements pour réitérer les opérations de dépôt.

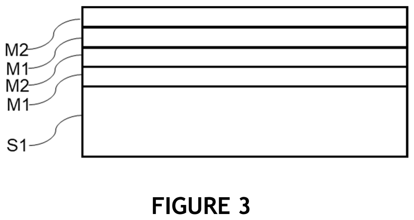

La figure 3 illustre de manière schématique un substrat sur lequel deux couches M1, M2 de matériaux différents ont été déposées de manière alternée.

### Application à la formation d'une couche de pérovskite

Bien que non limité à cette application, le dispositif selon l'invention est particulièrement bien adapté pour la formation d'une couche de pérovskite.

En effet, la formation d'une telle couche nécessite d'évaporer deux matériaux inorganiques à deux températures différentes et d'évaporer un troisième matériau organique à une troisième température, pendant que le substrat est maintenu à une quatrième température inférieure aux trois premières.

Pour la fabrication d'une couche de pérovskite, les matériaux inorganiques suivants peuvent être utilisés :
CsX avec X = I, Br ou Cl (la température d'évaporation/sublimation est comprise entre 350 et 550°C), le Cs pouvant être remplacé par K, Na ou Rb
PbX₂ avec X = I, Br ou Cl (la température d'évaporation/sublimation est comprise entre 200 et 450 °C).

Les matériaux organiques pouvant être utilisés pour la fabrication de la couche de pérovskite sont :
FAX avec X = I, Br, Cl (la température d'évaporation/sublimation est comprise entre 100 et 250°C)
MAX avec X = I, Br, Cl (la température d'évaporation/sublimation est comprise entre 100 et 200°C).

A titre uniquement indicatif, la fabrication d'une couche de pérovskite pour applications photovoltaïques peut comprendre la succession des étapes de dépôt suivantes :
(1) dépôt de 10 nm de CsBr à 400°C
(2) dépôt de 300 nm de Pbl₂ à 300°C,
(3) dépôt de FAI/FABr à 140°C pendant une durée suffisante pour permettre l'imprégnation des précurseurs organiques dans la matrice inorganique déposée pendant les étapes (1) et (2).

L'homme du métier est à même, selon les propriétés de la couche à fabriquer, de sélectionner les matériaux, températures et durée des dépôts appropriés.

Dès lors qu'il y a plus d'un substrat sur le carrousel, le temps de dépôt est le même pour chaque station de dépôt, la température est donc le seul moyen de régler la stoechiométrie.

La température peut être ajustée de manière dynamique mais, pour simplifier le procédé, il est préférable d'utiliser une température fixe pour chaque station de dépôt. Dans tous les cas, le carrousel permet de démarrer et de stopper le dépôt brutalement, grâce à la fonction « shutter » susmentionnée.

Le dépôt alterné permet de se rapprocher d'un dépôt multiple simultané (co-évaporation) tout en conservant les avantages de la technique CSS, notamment la vitesse de dépôt.

La fonction de refroidissement des substrats par l'intermédiaire du couvercle est également avantageuse car les matériaux inorganiques s'évaporent à une température largement supérieure à celle du substrat lors du dépôt.

Naturellement, le dispositif peut également être utilisé pour fabriquer tout autre matériau ou empilement de matériaux.

## Revendications

1. Dispositif de dépôt physique par sublimation à faible distance, comprenant :
- une enceinte (3) sous vide comprenant un corps (30) et un couvercle (40) monté hermétiquement sur le corps,
- au moins deux stations de dépôt (1, 2) comprenant chacune :
• un compartiment (10, 20) agencé dans le corps de l'enceinte (3) et comprenant un creuset (11, 21) adapté pour être rempli d'un matériau cible (12, 22), et
• un élément chauffant (13, 23) adapté pour chauffer le creuset (11, 21) à une température de sublimation du matériau cible,
chaque compartiment (10) étant découplé thermiquement d'un autre compartiment (20),
- un carrousel (4) adapté pour supporter au moins un substrat (S1, S2), le carrousel étant monté en rotation dans l'enceinte (3) pour positionner ledit substrat (S1, S2) de manière alternée en regard de chaque creuset (11, 21) pour permettre un dépôt d'une couche du matériau cible respectif sur le substrat, et
- des moyens de contrôle de la température (5) dudit au moins un substrat pour refroidir chaque substrat à une température inférieure à la température de sublimation de chaque matériau cible.

2. Dispositif selon la revendication 1, dans lequel les moyens de contrôle de la température du substrat comprennent un radiateur agencé dans ou sur le couvercle de l'enceinte pour évacuer la chaleur émise par chaque élément chauffant.

3. Dispositif selon l'une des revendications 1 ou 2, dans lequel les moyens de contrôle de la température du substrat comprennent un circuit de fluide agencé dans ou sur le couvercle.

4. Dispositif selon l'une des revendications 1 ou 2, dans lequel les moyens de contrôle de la température du substrat comprennent au moins un élément Peltier monté sur le couvercle.

5. Dispositif selon l'une des revendications 1 à 4, comprenant une unité de contrôle configurée pour piloter les éléments chauffants et la rotation du carrousel en fonction des matériaux cibles et de l'épaisseur de chaque couche à déposer sur le substrat.

6. Dispositif selon l'une des revendications 1 à 5, dans lequel le couvercle est amovible par rapport au corps par l'intermédiaire d'une glissière s'étendant dans une direction parallèle à l'axe de rotation du carrousel.

7. Dispositif selon l'une des revendications 1 à 6, dans lequel le carrousel (4) est agencé de sorte que la distance entre chaque substrat et un creuset en regard duquel ledit substrat est positionné soit inférieure ou égale à 10 mm.

8. Dispositif selon l'une des revendications 1 à 7, dans lequel le carrousel présente une pluralité d'ouvertures, chaque ouverture présentant un support pour un substrat respectif de sorte que ledit substrat comble l'ouverture.

9. Dispositif selon l'une des revendications 1 à 8, comprenant au moins un compartiment adapté pour ne pas être chauffé entre deux stations de dépôt.

10. Procédé de dépôt physique par sublimation à faible distance, comprenant :
- le chargement d'au moins deux matériaux cibles différents dans des creusets respectifs du dispositif selon l'une des revendications 1 à 9,
- la mise en place d'au moins un substrat sur le carrousel,
- le chauffage des creusets à une température de sublimation de chaque matériau cible respectif,
- la mise en rotation contrôlée du carrousel en regard des stations de dépôt, de sorte à déposer successivement sur chaque substrat une couche de chaque matériau cible respectif.

11. Procédé selon la revendication 10 dans sa relation de dépendance vis-à-vis de la revendication 9, dans lequel, avant et après le dépôt, le carrousel est placé dans une position dans laquelle chaque substrat est en regard d'un compartiment non chauffé.

12. Procédé selon l'une des revendications 10 ou 11 dans leur relation de dépendance vis-à-vis de la revendication 8, dans lequel le nombre de substrats est inférieur au nombre d'ouvertures dans le carrousel et chaque ouverture non comblée par un substrat est obturée par une plaque amovible.

13. Procédé selon l'une des revendications 10 à 12 pour former une couche de pérovskite sur ledit au moins un substrat, dans lequel les matériaux cibles sont des précurseurs de ladite pérovskite, la mise en rotation du carrousel étant contrôlée pour déposer, sur le substrat, des couches d'une épaisseur déterminée selon une proportion stœchiométrique.

14. Procédé selon la revendication 13, dans lequel les précurseurs comprennent deux matériaux inorganiques, tels que YX avec Y = Cs, K, Na ou Rb et X = I, Br ou Cl, et PbX₂ avec X = I, Br ou Cl, et un matériau organique, tel que FAX ou MAX avec X = I, Br ou Cl, chaque matériau présentant une température de sublimation différente.
